# EUROPEAN PATENT SPECIFICATION

(11) **EP 3 883 343 B1**
(45) Date of publication and mention of the grant of the patent: **12.10.2022**
(21) Application number: 21162104.0
(22) Date of filing: 11.03.2021
(51) Int. Cl.: H05B 6/12

(54) **ELECTRIC RANGE**
ELEKTRISCHE HERDPLATTE
CUISINIÈRE ÉLECTRIQUE

(30) Priority: 12.03.2020 KR 20200030996
(43) Date of publication of application: 22.09.2021
(73) Proprietor: LG Electronics Inc., Seoul 07336 (KR)
(72) Inventor: LEE, Jaeho, Seoul 08592 (KR); PARK, Il Young, Seoul 08592 (KR); KIM, Seunghak, Seoul 08592 (KR)
(74) Representative: Ter Meer Steinmeister & Partner

(56) References cited:
- EP-A1- 2 473 001
- EP-A2- 1 936 283
- WO-A1-2008/103009
- US-A1- 2010 044 367

## Description

### BACKGROUND

### 1. Field of Invention

Disclosed herein is an electric range.

### 2. Description of the Related Art

Various types of cooking appliances are used to heat food at homes or restaurants. The cooking appliances include gas ranges using gas and/or electric ranges using electricity.

The electric ranges are classified as resistance heating-type electric ranges and/or induction heating-type electric ranges.

In a resistance heating method, electric current is supplied to a metallic resistance wire or a non-metallic heat generation element such as silicon carbide to generate heat, and the generated heat is radiated or conducted to heat an object to be heated (e.g., a cooking vessel such as a pot, a frying pan and the like).

In an induction heating method, high-frequency power is supplied to a coil to generate a magnetic field around the coil, and eddy current produced in the generated magnetic field is used to heat an object to be heated made of a metallic material.

When electric current is supplied to a working coil or a heating coil, heat is generated while an object to be heated is inductively heated. The object to be heated is heated by the generated heat.

A working coil of an electric range of the related art, configured as described above, is disposed at an upper end of a base plate made of aluminum. The base plate is disposed at an upper end of a case constituting a space in which a substrate and electronic parts are disposed.

The working coil is made of a metallic material and has a predetermined weight. In the related art, elastic rods elastically supporting edges of the base plate are disposed in the case to support the base plate. When the working coil is disposed at an upper end of a center of the base plate, the center of the base plate bends downward.

Additionally, when each of the elastic rods has a different elastic force, the base plate tilts to one side without ensuring a balance.

Thus, in the related art, a constant gap between an object to be heated, mounted onto a cover disposed on the base plate, and a working coil cannot be ensured.

A device of the prior art is described in US 2010/044367.

### SUMMARY OF INVENTION

The present disclosure is directed to an electric range which prevents sagging of the base plate having a working coil to be disposed at an upper end thereof.

The present disclosure is also directed to an electric range that maintains a constant gap between an object to be heated and the working coil.

Aspects are not limited to the above ones, and other aspects and advantages that are not mentioned above can be clearly understood from the following description and can be more clearly understood from the embodiments set forth herein. Additionally, the aspects and advantages of the present disclosure can be realized via means and combinations thereof that are described in the appended claims.

The object is solved by the features of the independent claims. Preferred embodiments are given in the dependent claims.

In the electric range according to the present disclosure, a lower end of the base plate, which allows a working coil to be placed at the upper end thereof, may be supported by the elastic supporters disposed at the upper end of the air guide along a widthwise direction of the base plate, thereby preventing a bend of the base plate and maintaining a constant gap between an object to be heated and the working coil. Widthwise direction may be a direction along the short side walls of the case.

According to the present disclosure, the elastic members elastically supporting the lower surface of the base plate may be disposed at the upper end of the air guide disposed below/under the base plate, thereby preventing sagging of the base plate that allows a working coil to be placed at the upper end thereof.

According to the present disclosure, the lower surface of the base plate may supported by the elastic members disposed at the upper end of the air guide, thereby maintaining a constant gap between an object to be heated and the working coil.

According to an aspect of the present invention, an electric range is provided, comprising: a case which has an inner space in which a substrate and an air blowing fan are disposed, and an upper portion of which is open; a base plate disposed in the upper portion of the case; a working coil disposed on the base plate; and an air guide disposed under/below the base plate while disposed in the case, configured to cover the substrate, and having an inlet disposed at a front end of the air blowing fan; and an elastic supporter disposed between the air guide and the base plate, and configured to elastically support different positions of a lower surface of the base plate.

According to an aspect of the present invention, an electric range, comprising: a case having an inner space and an upper portion being open; a base plate disposed in the inner space to separate the inner space into the upper portion and a lower portion of the case; a substrate and an air blowing fan in the lower portion of the case, a working coil disposed in the upper portion and on the base plate; and an air guide disposed under/below the base plate in the lower portion of the case, the air guide is configured to cover the substrate, and having an inlet disposed at a front end of the air blowing fan; and an elastic supporter disposed between the air guide and the base plate, and configured to elastically support different positions of a lower surface of the base plate .

In one or more embodiments, which can be combined with the other embodiments, the air guide may have a predetermined length along a widthwise direction of the base plate,

In one or more embodiments, which can be combined with the other embodiments, one or more elastic supporters may be provided, spaced a predetermined distance apart along the widthwise direction.

In one or more embodiments, which can be combined with the other embodiments, the one or more elastic supporters may be disposed at one or more positions of an upper end of the air guide.

In one or more embodiments, which can be combined with the other embodiments, the one or more elastic supporters may be a leaf spring or elastic rubber block or sponge.

In one or more embodiments, which can be combined with the other embodiments, a fixing portion for fixing the one or more elastic supporters may be respectively disposed at one or more positions of the upper end of the air guide.

In one or more embodiments, which can be combined with the other embodiments, the fixing portion may comprise a pair of support projections spaced a predetermined distance apart at the upper end of the air guide and protruding upward.

In one or more embodiments, which can be combined with the other embodiments, a fixing projection having a first fixing hole protruding from the upper end of the air guide such that the fixing projection may be disposed between the pair of the support projections.

In one or more embodiments, which can be combined with the other embodiments, a lower end of the one or more elastic supporter may be mounted onto upper ends of the pair of support projections, while a lower end of the elastic supporter is mounted onto an upper end of the fixing projection.

In one or more embodiments, which can be combined with the other embodiments, a second fixing hole formed at the lower end of the elastic supporter may be mounted such that a position of the second fixing hole is aligned with a position of the first fixing hole.

In one or more embodiments, which can be combined with the other embodiments, the first fixing hole and the second fixing hole may be coupled through a fixing member.

In one or more embodiments, which can be combined with the other embodiments, each of the one or more elastic supporters may comprise a first fixed piece having a plate shape and fixed to the upper end of the air guide.

In one or more embodiments, each of the one or more elastic supporters may comprise a second fixed piece having a plate shape and configured to support a lower surface of the base plate.

In one or more embodiments, an elastic piece may be formed to spread apart and may be configured to connect one end of the first fixed piece and one end of the second fixed piece.

In one or more embodiments, which can be combined with the other embodiments, a movement guide groove may be formed at the upper end of the air guide along a lengthwise direction of the air guide,

In one or more embodiments, which can be combined with the other embodiments, the one or more elastic supporters may be coupled to the movement guide groove in a movable manner.

In one or more embodiments, which can be combined with the other embodiments, a reinforcing structure may be provided, preferably having a grid shape. The reinforcing structure may be formed at the upper end of the air guide.

In one or more embodiments, which can be combined with the other embodiments, a plurality of base plates may be disposed at an upper end of the case in a way that the plurality of base plates are adjacent to each other.

In one or more embodiments, which can be combined with the other embodiments, a plurality of elastic supporters may be provided to support a lower end of each of the base plates.

In one or more embodiments, a supporter may be further disposed on a bottom surface of the inner space of the case.

In one or more embodiments, which can be combined with the other embodiments, the supporter may be provided with a bracket both end portions of which are supported by the bottom surface of the inner space of the case.

In one or more embodiments, which can be combined with the other embodiments, one or more elastic members may be disposed at one or more positions of an upper end of the bracket and may elastically support a lower surface of the base plate.

In one or more embodiments, which can be combined with the other embodiments, the working coil may be disposed in a central portion of the base plate.

In one or more embodiments, which can be combined with the other embodiments, the elastic supporter may be disposed to support a lower end of the central portion of the base plate.

In one or more embodiments, which can be combined with the other embodiments, the elastic supporter may be disposed to support an area under/below a central portion of the working coil at the lower end of the base plate.

In another aspect of the invention, which can be combined with the other embodiments, an electric range is provided, comprising: a case which has an inner space in which a substrate and an air blowing fan are disposed, and an upper portion of which is open; a base plate disposed in the upper portion of the case; a working coil disposed on the base plate; an air guide disposed under/below the base plate while disposed in the case, configured to cover the substrate, and having an inlet disposed at a front end of the air blowing fan; an elastic supporter disposed between the air guide and the base plate, and configured to elastically support different positions of a lower surface of the base plate; and a supporter which is disposed on a bottom surface of the inner space of the case, and an upper end of which supports a lower end of the base plate along a widthwise direction of the base plate, wherein the air guide has a predetermined length along the widthwise direction of the base plate, a plurality of elastic supporters are provided, spaced a predetermined distance apart along the widthwise direction, and disposed at a plurality of positions of an upper end of the air guide, the supporter is provided with a bracket both end portions of which are supported by the bottom surface of the inner space of the case, and a plurality of elastic members is disposed at a plurality of positions of an upper end of the bracket and elastically supports a lower surface of the base plate, the bracket is provided with a bracket body having a predetermined length and width and having a linear shape and with a pair of support bodies bent at both ends of the bracket body, and the plurality of elastic members is disposed at an upper end of the bracket body, and the pair of support bodies is fixed onto the bottom surface of the inner space of the case.

In one or more embodiments, which can be combined with the other embodiments, the substrate may include at least one of a driving circuit, a heat sink, a power feeder or a filter circuit mounted thereon.

In one or more embodiments, which can be combined with the other embodiments, the electric range may further comprise a cover plate covering the open upper portion of the case.

The cover plate may be configured to place a an object to be heated thereon.

In one or more embodiments, which can be combined with the other embodiments, a plurality of working coils may be provided, wherein the elastic supporter may be disposed to support a lower surface of the base plate on which a heaviest working coil among the plurality of working coils is disposed.

In one or more embodiments, which can be combined with the other embodiments, the elastic supporter may be disposed to support an area of the base plate, on which the working coil is disposed.

In one or more embodiments, which can be combined with the other embodiments, a plurality of base plates may be provided and may be disposed to be adjacent to one another, wherein the elastic supporter may be disposed to support a lower portion of a base plate disposed at a center of among the plurality of base plates.

Specific effects are described along with the above-described effects in the section of Detailed Description.

### BRIEF DESCRIPTION OF DRAWING

The accompanying drawings constitute a part of the specification, illustrate one or more embodiments in the disclosure, and together with the specification, explain the disclosure, wherein:
FIG. 1 is a perspective view showing an electric range according to the present disclosure;
FIGS. 2 to 5 are perspective views showing the electric range in FIG. 1 without some components;
FIG. 6 is a perspective view showing an electric range having supporters of the present disclosure;
FIG. 7 is a perspective view showing a bracket according to the present disclosure;
FIG. 8 is another perspective view showing the bracket according to the present disclosure;
FIG. 9 is a perspective view showing an elastic member according to the present disclosure;
FIG. 10 is a perspective view showing a configuration in which a supporter according to the present disclosure elastically supports a lower portion of a base plate; and
FIG. 11 is a view showing an example in which a position of an elastic member according to the present disclosure can change at an upper end of a bracket.

### DETAILED DESCRIPTION OF EXEMPLARY EMBODIMENT

The above-described aspects, features and advantages are specifically described hereunder with reference to the accompanying drawings such that one having ordinary skill in the art to which the present disclosure pertains can easily implement the technical spirit of the disclosure. In the *disclosure, detailed description* of known technologies in relation to the disclosure *is* omitted if it is deemed to *make* the *gist* of the *disclosure* unnecessarily *vague.* Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

When one component is described as being "in an upper portion (or a lower portion)" of another component, or "on (or under)" another component, one component can be placed on the upper surface (or under the lower surface) of another component, and an additional component may be interposed between another component and one component on (or under) another component.

When one component is described as being "connected", "coupled", or "connected" to another component, one component can be directly connected, coupled or connected to another component. However, it is also to be understood that an additional component can be "interposed" between the two components, or the two components can be "connected", "coupled", or "connected" through an additional component.

Throughout the disclosure, each component can be provided as a single one or a plurality of ones, unless explicitly stated to the contrary.

The singular forms "a", "an" and "the" are intended to include the plural forms as well, unless explicitly indicated otherwise. It should be further understood that the terms "comprise" or "have" and the like, set forth herein, are not interpreted as necessarily including all the stated components or steps but can be interpreted as including some of the stated components or steps or can be interpreted as further including additional components or steps.

Throughout the disclosure, the terms "A and/or B" as used herein can denote A, B or A and B, and the terms "C to D" can denote C or greater and D or less, unless stated to the contrary.

Below, an electric range is described with reference to several embodiments.

The electric range in the disclosure may include an electric resistance-type electric range and an induction heating-type electric range (i.e., an electric range). For convenience, an electric range, provided with a working coil as a heating unit, is described as an example during description of the embodiments. However, embodiments are not limited to those set forth herein.

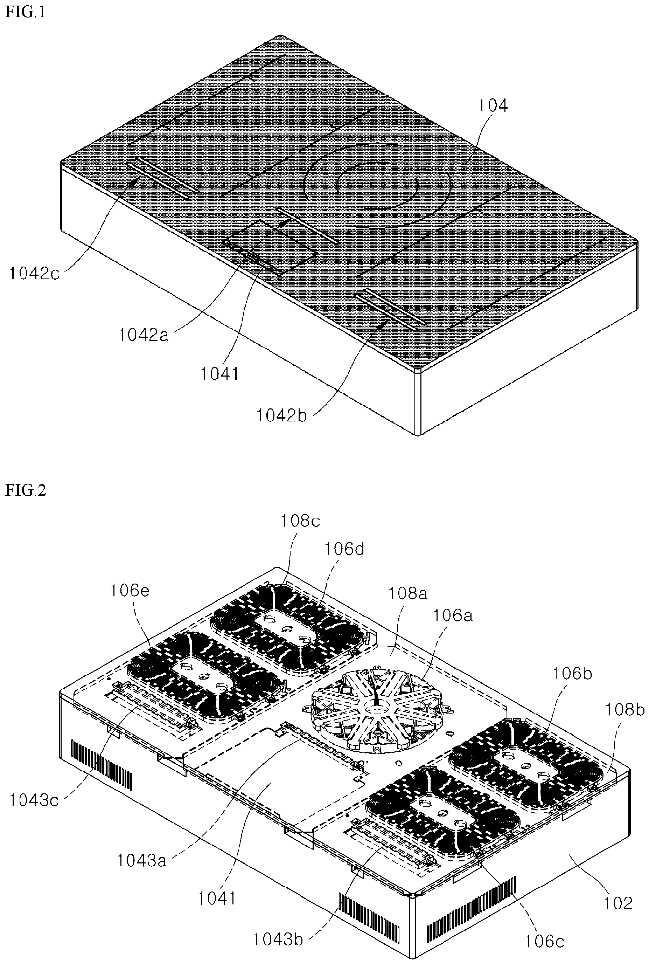

FIG. 1 is a perspective view showing an electric range 100 according to the present disclosure. FIGS. 2 to 5 are perspective views showing the electric range 100 in FIG. 1 without some components.

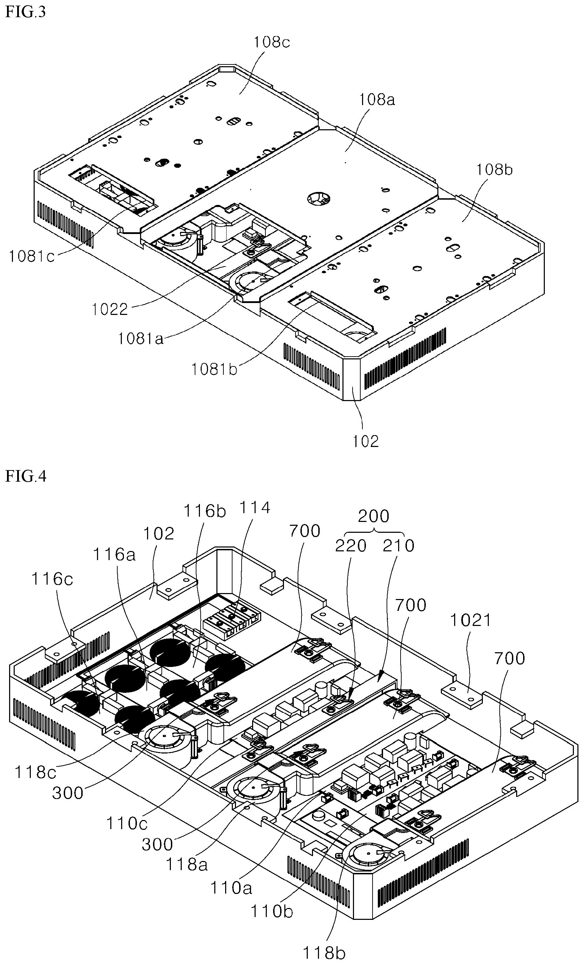

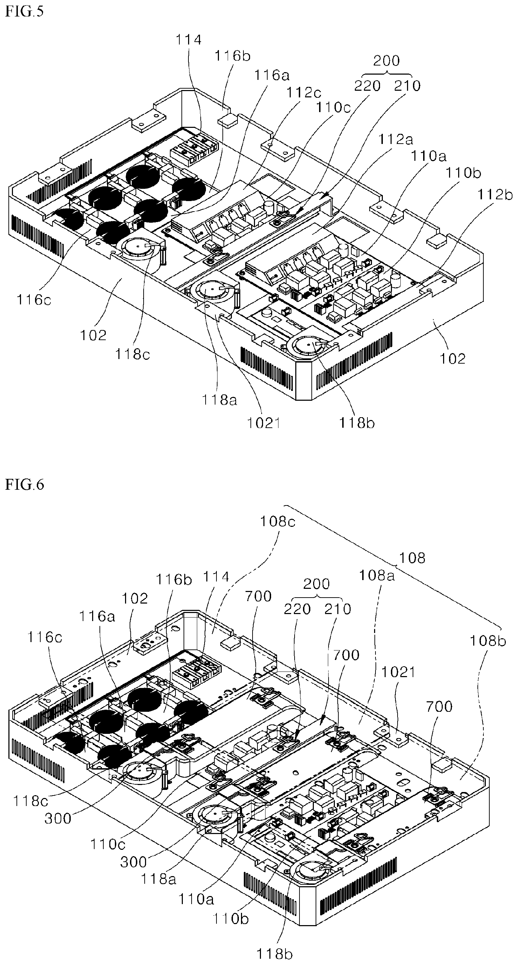

Specifically, FIG. 2 is a view showing the electric range 100 in FIG. 1 without a cover plate 104, FIG. 3 is a view showing the electric range 100 in FIG. 1 without a cover plate 104 and a working coil 106a, 106b, 106c, 106d, 106e, FIG. 4 is a view showing the electric range 100 in FIG. 1 without a cover plate 102, a working coil 104, and a base plate 108a, 108b, 108c, and FIG. 5 is a view showing the electric range 100 in FIG. 1 without a cover plate 102, a working coil 104, a base plate 108a, 108b, 108c and an air guide 700.

Referring to FIGS. 1 to 5, the electric range 100 according to one embodiment may include a case 102, a cover plate 104, a working coil 106a, 106b, 106c, 106d, 106e, a base plate 108a, 108b, 108c, a driving circuit 110a, 110b, 110c, a heat sink 112a, 112b, 112c, a power feeder 114, a filter circuit 116a, 116b, 116c, an air blowing fan 118a, 118b, 118c, and air guides 700.

The case 102 may protect and/or accommodate components in the electric range 100. For example, the case 102 may be made of aluminum or any other metal but not limited. The case 102 may be thermally insulated to prevent heat, generated by the working coil 106a, 106b, 106c, 106d, 106e, from leaking outward. The case 102 is formed to have a predetermined height. The case 102 has two short side portions and two long side portion being connected or integrally formed to form a frame which surrounds the inner space. The case 102 is open at its upper portion and may be closed at the bottom surface 102b with a bottom plate.

The cover plate 104 may be coupled to an upper end of the case 102 to shield an inside of the case 102, and an object to be heated (not illustrated, an object to be heated by at least one of the working coils 106a, 106b, 106c, 106d, 106e) may be placed on an upper surface of the cover plate 104.

An object to be heated such as a cooking vessel may be placed on the upper surface of the cover plate 104, and heat generated by the at least one working coil 106a, 106b, 106c, 106d, 106e may be delivered to the object to be heated through the upper surface of the cover plate104.

The cover plate 104 may be made of glass but not limited.

An input interface 1041 configured to receive an input from a user may be disposed on the upper surface of the cover plate 104. The input interface 1041 may be buried into the upper surface of the cover plate 104 in a flat manner and may display a specific image. The input interface 1041 may receive a touch input from the user, and the electric range 100 may be driven based on the received touch input.

Specifically, the input interface 1041 may be a module for controlling the operation of the electric range, in particular by inputting a heating intensity or a heating period and the like desired by the user, and may be implemented as a physical button or a touch panel and the like. Additionally, the input interface 1041 may display a driving state of the electric range 100.

For example, the input interface 1041 may be a liquid crystal display (TFT LCD), LED or OLED but not limited.

Light display areas 1042a, 1042b,1042c may be formed on the upper surface of the cover plate 104. Light source units 1043a, 1043b, 1043c may be disposed under/below the cover plate 104, and light emitted from the light source units 1043a, 1043b, 1043c may be delivered to the user through the light display areas 1042a, 1042b, 1042c.

The working coil 106a, 106b, 106c, 106d, 106e may be a heating unit that heats an object to the heated, and may be disposed in the case 102.

The working coil 106a, 106b, 106c, 106d, 106e may include a wire that is wound multiple times in a ring shape, and may generate an AC magnetic field. Additionally, a mica sheet and/or a ferrite core may be consecutively disposed on a lower side of the working coil 106a, 106b, 106c, 106d, 106e.

The ferrite core may be fixed to the mica sheet through a sealant, and may diffuse the AC magnetic field generated by the working coil 106a, 106b, 106c, 106d, 106e. The mica sheet may be fixed to the working coil 106a, 106b, 106c, 106d, 106e and the ferrite core through the sealant, and may prevent a direct delivery of the heat, generated by the working coil 106a, 106b, 106c, 106d, 106e, to the ferrite core.

A plurality of working coils 106a, 106b, 106c, 106d, 106e may be provided.

The plurality of working coils 106a, 106b, 106c, 106d, 106e may include a first working coil 106a disposed in a central portion of the case 102, a second working coil 106b and/or a third working coil 106c disposed on a right side of the first working coil 106a, and a fourth working coil 106d and/or a fifth working coil 106e disposed on a left side of the first working coil 106a. The second working coil 106b and/or the third working coil 106c may be disposed on the right side of the first working coil 106a in an up-down direction, and the fourth working coil 106d and/or the fifth working coil 106e may be disposed on the left side of the first working coil 106a in the up-down direction.

For example, the first working coil 106a may be a high-output dual heating coil, and at least one of the second working coil 106b, the third working coil 106c, the fourth working coil 106d and/or the fifth working coil 106e may be a single heating coil and/or having a lower output than the first coil.

The first working coil 106a as a dual heating coil may be heavy and may have a maximum output of 7000 kW.

The electric range 100 according to one embodiment may perform the function of wireless power transmission based on the configurations and features described above.

Technologies for wirelessly supplying power have been developed and have been used for a wide range of electronic devices. A battery of an electronic device, to which the wireless power transmitting technology is applied, can be charged only by being placed on a charge pad without connecting to an additional charge connector. Accordingly, the electronic device, to which the wireless power transmitting technology is applied, requires no cord or no charger, thereby ensuring improved mobility and a reduced size and weight.

The wireless power transmitting technology can be broadly classified as an electromagnetic induction technology using a coil, a resonance technology using resonance, and a radio emission technology for converting electric energy into microwaves and delivering the microwaves, and the like. In the electromagnetic induction technology, power is transmitted using electromagnetic induction between a primary coil (e.g., a working coil) included in an apparatus for wirelessly transmitting power and a secondary coil included in an apparatus for wirelessly receiving power.

The theory of the induction heating technology of the electric range 100 is substantially the same as that of the electromagnetic induction-based wireless power transmission technology, in that an object to be heated is heated using electromagnetic induction. Accordingly, the electric range 100 according to one embodiment may perform the function of wireless power transmission as well as the function of induction heating.

The base plate 108a, 108b, 108c may be disposed at a middle end of the case 102, and the plurality of working coils 106a, 106b, 106c, 106d, 106e may be disposed on the base plates 108a, 108b, 108c.. So the one or more base plates may separate the inner space of the case into a lower portion and an upper portion. The upper portion is for accommodating the working coils. The lower portions is provided for accommodating the electronic components.

The base plate 108a, 108b, 108c may support the plurality of working coils 106a, 106b, 106c, 106d, 106e that are heavy, and may help the plurality of working coils 106a, 106b, 106c, 106d, 106e to be mounted. The input interface 1041 and the light source unit 1043a, 1043b,1043c may be further disposed on/in the upper portion of the base plate 108a, 108b, 108c.

According to one embodiment, a plurality of base plates 108a, 108b, 108c may be provided but not limited. Alternatively, a single base plate may be disposed in the case 102.

According to one embodiment, the plurality of base plates 108a, 108b, 108c may include a first base plate 108a, a second base plate 108b, and a third base plate 108c.

The first base plate 108a, the second base plate 108b, and the third base plate 108c may be disposed at the middle end of the case 102 side by side. Middle end means a position lower than the upper edge of the case and higher as the bottom surface of the case.

The first base plate 108a may be disposed in a central portion of the middle end of the case 102. The first working coil 106a may be disposed on/in an upper portion of the first base plate 108a.

The input interface 1041, and a first light source unit 1043a corresponding to the first working coil 106a may be further disposed on/in the upper portion of the first base plate 108a. On/In the upper portion of the first base plate 108a, the input interface 1041 may be disposed on a lower side of the first light source unit 1043a, and the first light source unit 1043a may be disposed on a lower side of the input interface 1041. The first base plate 108a may have a through hole A 1081a for installing the input interface 1041 and the first light source unit 1043a.

The second base plate 108b may be disposed on a right side of the first base plate 108a at the middle end of the case 102. The second working coil 106b and the third working coil 106c may be disposed on/in an upper portion of the second base plate 108b.

A second light source unit 1043b corresponding to the second working coil 106b and the third working coil 106c may be further disposed on/in the upper portion of the second base plate 108b. On/In the upper portion of the second base plate 108b, the second working coil 106b, the third working coil 106c and the second light source unit 1043b may be consecutively disposed. The second base plate 108b may have a through hole B 1081b for installing the second light source unit 1043b.

The third base plate 108c may be disposed on a left side of the first base plate 108a at the middle end of the case 102. The fourth working coil 106d and the fifth working coil 106e may be disposed on/in an upper portion of the third base plate 108c.

At least one of the first, second and third base plate might have an inclined corner or cut corner, to thereby facilitate the assembling of the base plates on the mounting portions extending inside the case, where the edges of the first, second and third base plate are supported or rest on.

A third light source unit 1043c corresponding to the fourth working coil 106d and the fifth working coil 106e may be further disposed on/in the upper portion of the third base plate 108c. On/In the upper portion of the third base plate 108c, the fourth working coil 106d, the fifth working coil 106e and the third light source unit 1043c may be consecutively disposed. The third base plate 108c may have a through hole C 1081c for installing the third light source unit 1043c.

The case 102 may have a plurality of mounting portions 1021 for mounting the plurality of base plates 108a, 108b, 108c in portions of an outer circumferential surface of the case 102. The mounting portions are bent inside the inner space to provide a support surface for the base plates. That is, edges of the plurality of base plates 108a, 108b, 108c may be mounted onto tops of the plurality of mounting portions 1021. Accordingly, the plurality of base plates 108a, 108b, 108c may be disposed at the middle end of the case 102.

The second base plate 108b and the third base plate 108c may be disposed on both sides of the first base plate 108a.

The first base plate 108a may be disposed between the second base plate 108b and the third base plate 108c.

Portions of lower surfaces of three outer edges or circumferences of each of the second base plate 108b and the third base plate 108c may be supported by the mounting portions 1021 disposed on the outer circumferential surface of the case 102.

A supported portion of the first base plate 108a between the second base plate 108b and the third base plate 108c may be smaller than the supported portions of the second and third base plates 108b, 108c. This is in particular true, as the first base plate is only supported at the one or more mounting portions 1021 at the long side walls of the case, e.g. the lower and upper side of the case. This is different for the second and third base plates 108b, and 108c, which are supported additionally by mounting portions 1021 extending from the short side wall of the case. Thus, these base plates 108b, 108c are supported at three side edges. The first base plate being arranged in the middle is only supported at two opposing side edges.

Thus, a center of the first base plate 108a may sag.

Therefore, it is advantageously if the air guide 700 may be disposed under/in a lower portion of the first base plate 108a and if an elastic supporter 300 may be disposed at an upper end of the air guide 700. Thus, the elastic supporter 300 may support a lower portion of the first base plate108a between the second base plate 108b and the third base plate 108c. Thus, the center of the first base plate 108a may be prevented from sagging.

A bracket 210 may be disposed in a central portion of a lower end of the case 102. The bracket 210 may be disposed in a central portion of a lower side of the first base plate 108a, and may prevent a bend (i.e., sagging of the first base plate 108a), caused by weight of the first base plate 108a. The weight of the first base plate 108a may include the weight of the first working coil 106a on/in the upper portion of the first base plate 108a.

At least one elastic member 220 may be disposed on the bracket 210. For example, the elastic member 220 may be a leaf spring. An upper end of at least one elastic member 220 may contact the lower surface of the first base plate 108a, and may prevent a bend of the first base plate 108a. The configuration and mechanism for prevention of the bend are described hereunder.

The driving circuit 110a, 110b, 110c may control driving of the plurality of working coils 106a, 106b, 106c, 106d, 106e that are heating units, and may further control driving of components such as the input interface 1041 and the like of the electric range 100.

The driving circuit 110a, 110b, 110c may include various components in relation to the driving of the working coils 106a, 106b, 106c, 106d, 106e. The components may include a power supply configured to supply AC power, a rectifier configured to rectify AC power of the power supply into DC power, an inverter configured to convert DC power, rectified by the rectifier, into resonance current as a result of a switching operation and supply the resonance current to the working coil 106, a microcomputer (i.e., a micom) configured to control the inverter and components in relation to driving of the inverter, a relay or a semiconductor switch configured to turn on or turn off the working coils 106a, 106b, 106c, 106d, 106e, and the like.

The driving circuit 110a, 110b, 110c may include a first driving circuit 110a, a second driving circuit 110b, and a third driving circuit 110c. The first driving circuit 110a may be disposed on a right side of the lower end of the case 102 with respect to the bracket 210 and may control driving of the first working coil 106a. The second driving circuit 110b may be disposed on a right side of the first driving circuit 110a and may control driving of the second working coil 106b and the third working coil 106c. The third driving circuit 110c may be disposed on a left side of the lower end of the case 102 with respect to the bracket 210 and may control driving of the fourth working coil 106d and the fifth working coil 106e.

The heat sink 112a, 112b, 112c may be disposed over a portion of the driving circuit 110a, 110b, 110c and may prevent an increase in temperatures of components disposed in a portion of the driving circuit 110a, 110b, 110c.

The heat sink 112a, 112b, 112c may include a first heat sink 112a, a second heat sink 112b, and a third heat sink 112c. The first heat sink 112a may prevent an increase in temperatures of components installed in a portion of the first driving circuit 110a, the second heat sink 112b may prevent an increase in temperatures of components installed in a portion of the second driving circuit 110b, and the third heat sink 112c may prevent an increase in temperatures of components installed in a portion of the third driving circuit 110c.

The power feeder 114 may supply an external power from an external power source to the electric range 100. The power feeder 114 may be implemented as a terminal block.

The power feeder 114 may be disposed at any one of edges of the lower portion of the case 102. For example, the power feeder 114 may be disposed at an upper end of the left side of the lower end of the case 102.

The filter circuit 116a, 116b, 116c may be disposed at any one of the edges of the lower end of the case 102, and may reduce noise made by the plurality of working coils 106a, 106b, 106c, 106d, 106e.

The filter circuit 116a, 116b, 116c may include a first filter circuit 116a, a second filter circuit 116b, and a third filter circuit 116c.

The first filter circuit 116a may reduce noise made by the first working coil 106a. The second filter circuit 116b may reduce noise made by the second working coil 106b and the third working coil 106c. The third filter circuit 116c may reduce noise made by the fourth working coil 106d and the fifth working coil 106e.

The air blowing fan 118a, 118b, 118c may be provided for decreasing or pulling down a temperature inside the case 102. Accordingly, the air blowing fan 118a, 118b, 118c may lower a temperature of various components installed in the driving circuit 110a, 110b, 110c.

The air blowing fan 118a, 118b, 118c may include a first air blowing fan 118a, a second air blowing fan 118b, and a third air blowing fan 118c.

The first air blowing fan 118a may cool various components installed in the first driving circuit 110a and may further cool the light source unit 1043a corresponding to the first working coil 106a. In particular, the first air blowing fan 118a may deliver air (wind) for cooling to the first heat sink 112a over the first driving circuit 110a.

The second air blowing fan 118b may cool various components installed in the second driving circuit 110b and may further cool the light source unit 1043b corresponding to the second working coil 106b and the third working coil 106c. In particular, the second air blowing fan 118b may deliver air for cooling to the second heat sink 112b over the second driving circuit 110b.

The third air blowing fan 118c may cool various components installed in the third driving circuit 110c and may further cool the light source unit 1043c corresponding to the fourth working coil 106d and the fifth working coil 106e. In particular, the third air blowing fan 118c may deliver air for cooling to the third heat sink 112c over the third driving circuit 110c.

The air blowing fan 118a, 118b, 118c may be provided with a structure for preventing a foreign substance from contacting the air blowing fan 118a, 118b, 118c.

The air guide 700 may guide air (wind) generated by the air blowing fan 118a, 118b, 118c.

The air guide 700 may include a first air guide, a second air guide and a third guide.

The first air guide 700 may be disposed to encircle or enclose the first heat sink 112a installed over a portion of the first driving circuit 110a and may guide (deliver) air, output from the first air blowing fan 118a, to the first heat sink 112a.

The second air guide 700 may be disposed to encircle the second heat sink 112b installed over a portion of the second driving circuit 110b and may guide air, output from the second air blowing fan 118b, to the second heat sink 112b.

The third air guide 700 may be disposed to encircle the third heat sink 112c installed over a portion of the third driving circuit 110c and may guide air, output from the third air blowing fan 118c, to the third heat sink 112c.

FIG. 6 is a perspective view showing an electric range according to the present disclosure.

Referring to FIG. 6, the electric range 100 according to the disclosure may include a case 102, a base plate 108a, 108b, 108c (see FIG. 3), a working coil 106a, 106b, 106c, 106d, 106e, and an elastic supporter 300, as described above.

The case 102 may be formed as a plate member having a rectangular shape an upper portion of which is open, like a frame. That is, the case 102 may include four walls and one bottom surface. The bottom portion may be closed by a bottom plate.

Referring to FIG. 3, the base plate 108a, 108b, 108c may include first, second and third base plates 108a, 108b, 108c.

The working coil 106a, 106b, 106c, 106d, 106e may include first, second, third, fourth and fifth working coils 106a, 106b, 106c, 106d, 106e.

The first working coil 106a may be disposed an upper end of the first base plate 108a. The second and third working coils 106b, 106c may be spaced a predetermined distance apart at an upper end of the second base plate 108b. The fourth and fifth working coils 106d, 106e may be spaced a predetermined distance apart at an upper end of the third base plate 108c.

The first, second and third base plates 108a, 108b, 108c may be disposed in a way that the first, second and third base plates 108a, 108b, 108c are adjacent to each other. The first, second and third base plates 108a, 108b, 108c may be disposed at an upper end of the case 102.

The above-described driving circuit 110a, 110b, 110c may be disposed in the case 102. The driving circuit 110a, 110b, 110c may be a printed circuit board (PCB). The driving circuit 110a, 110b, 110c may be provided with a plurality of electronic parts. When the electronic parts are driven, the driving circuit 110a, 110b, 110c may generate a certain amount of heat.

The above-described air blowing fan 118a, 118b, 118c may be disposed near the driving circuit 110a, 110b, 110c. The air blowing fan 118a, 118b, 118c may supply predetermined-temperature air for cooling to the driving circuit 110a, 110b, 110c from the outside, to allow the driving circuit 110a, 110b, 110c to dissipate heat.

The case 102 may be provided with an air guide 700, therein. The number of the air guides 700 may correspond to the number of the driving circuits 110a, 110b, 110c. The air guide 700 may guide air, generated through the air blowing fan 118a, 118b, 118c, to the driving circuit 110a, 110b, 110c.

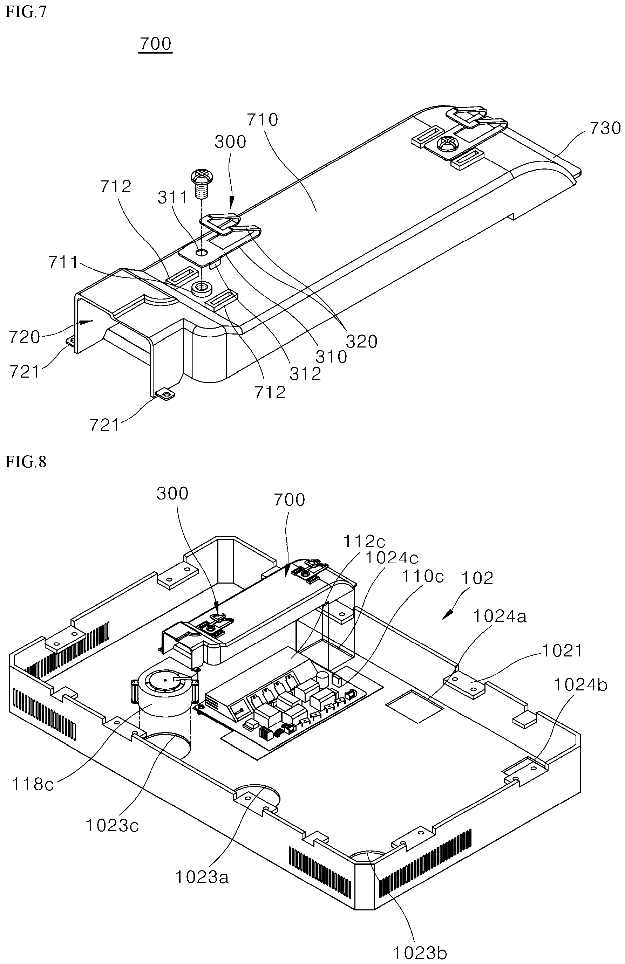

The air guide 700 may be configured to cover the driving circuit 110a, 110b, 110c. An inlet 720 (see FIG. 7) formed at one end of the air guide 700 may be open. The inlet 720 may be connected to an outlet of the air blowing fan 118a, 118b, 118c through which air is discharged. The outlet of the air blowing fan 118a, 118b, 118c may be inserted into the inlet 720 of the air guide 700, to connect to the inlet 720 of the air guide 700.

Accordingly, air supplied through the outlet of the air blowing fan 118a, 118b, 118c may be readily guided to an entire area of the driving circuit 110a, 110b, 110c through the air guide 700. The air guide 700 may prevent loss of air, discharged through the air blowing fan 118a, 118b, 118c, to an outside area of the driving circuit 110a, 110b, 110c.

A configuration of the air guide 700 is described hereunder.

FIG. 7 is a perspective view showing an air guide according to the present disclosure. FIG. 8 is a perspective view showing a state in which an air guide according to the present disclosure is installed.

Below, reference numeral "700" is given to the air guide, "110" is given to the driving circuit, "108" is given to the base plate, and "108" is given to the air blowing fan.

The air guide700, as described above, may be disposed in the case 102 to cover each of the driving circuits 110.

Referring to FIG. 7, the air guide 700 may include a housing 710. The housing 710 may have a " 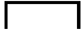 "-shaped cross section (open U-shape or channel type) in a lengthwise direction. The housing 710 may have an inner surface corresponding to the above shape. The housing 710 may have a predetermined length. The length of the housing 710 may be greater than a length of the driving circuit 110 by a predetermined length. Additionally, a width of the housing 710 may be greater than a width of the driving circuit 110 by a predetermined width. The housing 710 may have a lower portion that is open. Accordingly, the housing 710 may have a structure in which the housing 710 covers the driving circuit 110.

The housing 710 may have an inlet 720 at one end thereof, and the inlet 720 may be open. A coupling hole 721 may be respectively formed at lower ends of both walls of the inlet 720. Referring to FIG. 8, the coupling hole 721 may be coupled to another coupling hole (not illustrated) on a bottom surface of the case 102 through a coupling member (not illustrated).

The other end side of the housing 710 may be formed into a bent shape having a predetermined curvature along a downward direction.

The housing 710 may have a held jaw or protrusion 730 at an end of the other end thereof. The held jaw 730 may be a component to be held in any one of a 2-1th through hole 1024a, or a 2-2th through hole 1024b and a 2-3th through hole 1024c that are made on the bottom surface of the case 102.

Accordingly, the housing 710 may be installed on the bottom surface of the case 102 in the state in which the housing 710 covers an upper portion of the above-described driving circuit 110. An inner surface of the housing 710 may be spaced a predetermined distance apart from the upper portion of the driving circuit 110.

Herein, the inlet 720 formed at one end of the housing 710 may connect to the outlet of the air blowing fan 118.

A flow of air discharged from the outlet of the air blowing fan 118 may be guided such that the air is supplied to the driving circuit 110 along the inner surface of the housing 710. The driving circuit 110 may dissipate heat using the supplied air.

The air guide 700 according to the present disclosure may be made of heat-resistant plastics. The air guide 700 may also be made of aluminum. Additionally, the air guide 700 may be further provided with heat dissipation pins (not illustrated) on an outside of the air guide 700.

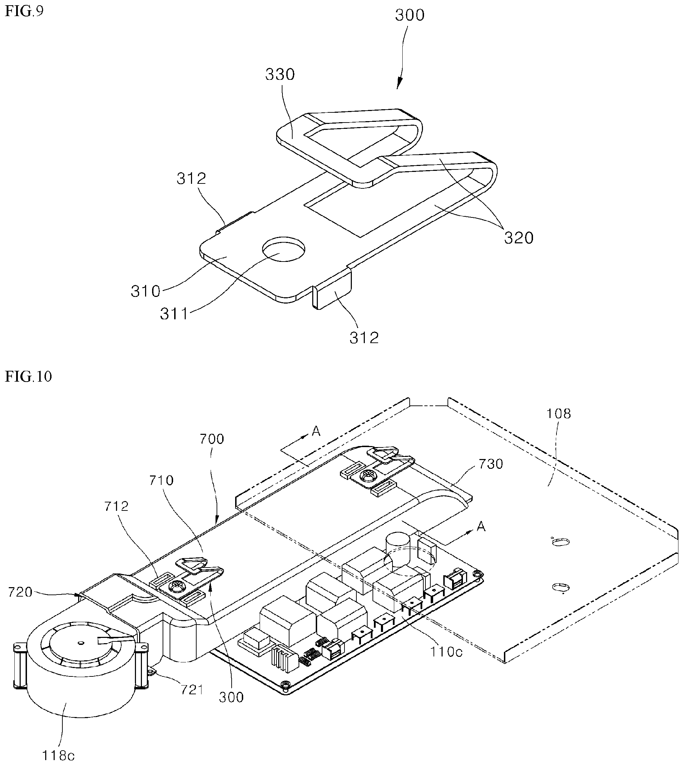

FIG. 9 is a perspective view showing a configuration of an elastic supporter according to the present disclosure.

Referring to FIG. 9, the elastic supporter 300 according to the disclosure may be disposed at a plurality of positions of an upper end of the above air guide 700. The elastic supporter 300 may be a leaf spring. The elastic supporter 300 may also be an elastic member that can return to its original shape using elasticity, in addition to the leaf spring.

A plurality of elastic supporters 300 described above may be disposed at a plurality of positions of an upper end of the housing 710.

Lower ends of the plurality of elastic members 300 may be fixed to the upper end of the housing 710. Upper ends of the plurality of elastic members 300 may elastically support a plurality of positions of a lower surface of the base plate 108.

Each of the plurality of elastic members 300 may have the same configuration.

Each of the elastic members 300 may be formed into a V-shaped leaf spring. The elastic member 300 may include a fixed piece 310, an elastic piece 320 and a support piece 330.

The fixed piece 310 may be fixed to a predetermined position of the upper end of the housing 710. The fixed piece 310 may have a fixing hole 311. A pair of position determination projections 312 bent along the downward direction may be formed in both side portions of the fixed piece 310. The position determination projection 312 may be formed into a rectangular piece.

The housing 710 may have another fixing hole 711 at a predetermined position thereof. A pair of position determination holes 712 may be formed in both side portions of another fixing hole 711. The position determination holes 712 may be formed into a rectangular hole. A fixing member (not illustrated) may be coupled to the fixing hole 311 and another fixing hole 711. Accordingly, the fixed piece 310 may be fixed to the upper end of the housing 710. The pair of position determination projections 312 may be fitted into the pair of position determination holes 712.

The support piece 330 may be disposed over the fixed piece 310. The fixed piece 310 may support the lower surface of the base plate 108 disposed on the housing 710.

The elastic piece 320 may have a predetermined level of elasticity. The elastic piece 320 may elastically connect the fixed piece 310 and the support piece 330. A lower end of the elastic piece 320 may connect to one end of the fixed piece 310, and the other end may connect to one end of the support piece 330. The elastic piece 320 may have a V shape that spreads apart in one direction/toward one side.

The elastic piece 320 may be formed into a body that is branched into two at one end of the fixed piece 310. The support piece 330 may connect to an upper end of the elastic piece 320 branched into two, in a plate form.

A lower surface of each of the base plates 108 may be supported by the support piece 330. The fixed piece 310 may be fixed to the upper end of the housing 710. The elastic piece 320 may elastically support the lower surface of each of the base plates 108, between the fixed piece 310 and the support piece 330.

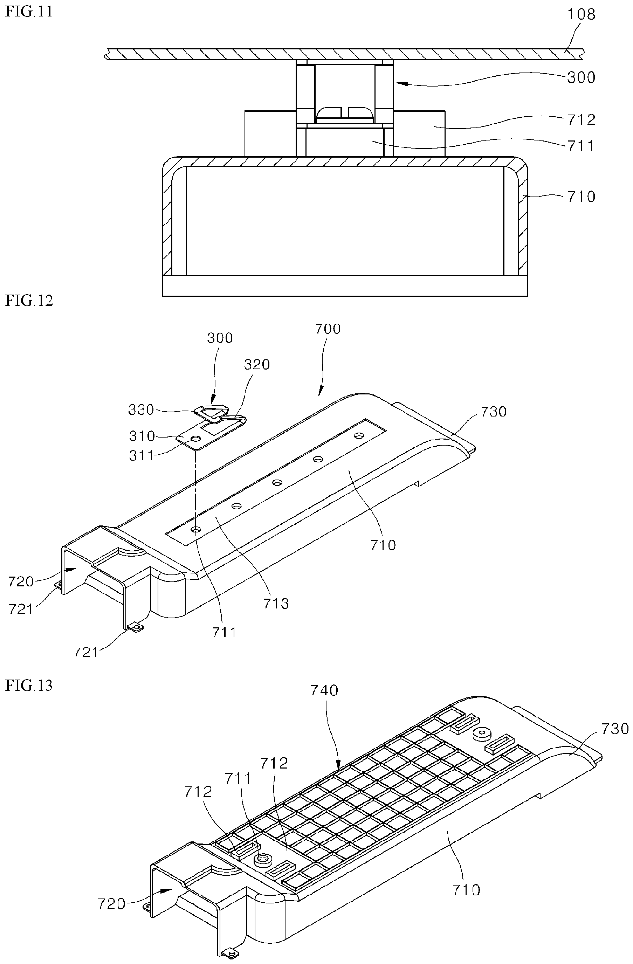

FIG. 10 is a perspective view showing a state in which a base plate is supported by an elastic supporter on an air guide according to the present disclosure. FIG. 11 is a cross-section view along line A-A in FIG. 10 and a cross-sectional view showing a coupling of configurations of an air guide, an elastic supporter and a base plate according to the present disclosure.

A mechanism for preventing sagging of the base plate 108 according to the present disclosure is described with reference to FIGS. 10 and 11.

A plurality of elastic supporters 300 may be disposed at the upper end of the air guide 700 having the above configuration. When a plurality of air guides 700 described above is provided, a plurality of elastic supporters 300 may be respectively disposed at the upper end of each of the air guides 700.

Referring to FIGS. 10 and 11, the elastic supporters 300 formed into a leaf spring may be disposed at a plurality of positions of the upper end of the housing 710 of the air guide 700. The upper end of the elastic supporter 300 is not fixed.

The base plate 108 may be disposed on the air guide 700. The working coil 106a, 106b, 106c, 106d, 106e (see FIG. 2) having a predetermined weight may be disposed at the upper end of the base plate 108. The base plate 108 may be made of aluminum having a predetermined thickness. Accordingly, self-weight of the working coil 106a, 106b, 106c, 106d, 106e may be applied downward depending on the weight of the working coil 106a, 106b, 106c, 106d, 106e. As a result, the base plate 108 may bend downward at a position where the working coil 106a, 106b, 106c, 106d, 106e is disposed.

The plurality of elastic supporters 300 according to the present disclosure may elastically support the lower surface of the base plate 108. For example, the plurality of elastic supporters 800 may be disposed in an area included in the area where the working coil 106a, 106b, 106c, 106d, 106e is disposed.

The plurality of elastic supporters 300 may elastically support the lower surface of the base plate 108 at a position corresponding to the area where the working coil 106a, 106b, 106c, 106d, 106e is disposed, at the upper end of the air guide 700. Thus, the plurality of elastic supporters 300 according to the disclosure may prevent deformation such as downward sagging or a downward bend and the like of the base plate 108, and may reduce heat generated by the working coil 106a, 106b, 106c, 106d, 106e as a result of reduction in resonance current by maintaining a constant gap between the working coil and an object to be heated over the working coil 106a, 106b, 106c, 106d, 106e.

The air guide 700 according to the present disclosure may be disposed below/under each of the base plates 108, as illustrated in FIG. 6. A plurality of elastic supporters 300 may be disposed at the upper end of each of the air guides 700. Accordingly, the lower surface of each of the base plates 108 may be elastically supported by the elastic supporters 300 disposed at the upper end of each of the air guides 700. That is, each base plate 108 may be prevented from sagging downward as a result of support from each elastic supporter 300.

Referring to FIGS. 2, 3 and 6, a central portion of the first base plate 108a on which the first working coil 106a is disposed may sag further than any other areadue to the weight of the first working coil 106a.

To solve the problem, the elastic supporters 300 at the upper end of the air guide 700 according to the disclosure may be disposed to support the central portion of the lower surface of the first base plate 108a.

Alternatively, the elastic supporters 300 at the upper end of the air guide 700 may be disposed to support a portion under a central portion of the first working coil 106a while supporting a portion under the area in which the first working coil 106a is installed.

Additionally, since the dual-type first working coil 106a weighs more than any other working coil (the second, third, fourth and fifth working coils 106b, 106c, 106d, 106e), the elastic supporters 300 at the upper end of the air guide 700 may support the lower surface of the first base plate 108a on a lower side the first working coil 106a.

The structure in which the elastic supporter 300 is disposed at the upper end of each air guide 700 and supports the lower surface of each base plate 108 is described above.

Referring to FIG. 6, a supporter 200 may be further formed on a bottom surface of an inner space of the case 102 according to the present disclosure.

The supporter 200 may include a bracket 210 having a linear shape.

Both ends of the bracket 210 may be bent at a right angle. The bent portion may be fixed onto the bottom surface of the case 102. The bracket 210 may have a predetermined length and may be spaced from a lower portion of the base plate 108.

Other elastic members 220 having the same shape as the elastic supporter 300 described above may be disposed at a plurality of positions of an upper end of the bracket 210.

Accordingly, other elastic supporters 220 may additionally provide an elastic support to the lower surface of the base plate 108 elastically in a state of being fixed to a plurality of positions of the upper end of the bracket 210.

Thus, the lower surface of the base plate 108 may be supplementarily supported as a result of provision of the bracket 210 having other elastic supporters 220 described above, according to the disclosure. With the configuration, the base plate 108 may be prevented from sagging downward. Additionally, when the return elasticity of any one or all of the elastic supporters 220 is reduced, other elastic supporters 220 described above may supplement the elastic supporters 300 to stably support the base plate 108.

Further, other elastic supporters 220 described above may be disposed at a predetermined position of the upper end of the bracket 210 to be placed in a lower area where the working coil 106a, 106b, 106c, 106d, 106e is disposed. When the working coil 106a, 106b, 106c, 106d, 106e is disposed in the central portion of the base plate 108, other elastic supporters 220 described above may be disposed at a center of the upper end of the bracket 210, for example.

FIG. 12 is a view showing an example in which positions of elastic supporters according to the present disclosure can change at an upper end of an air guide.

Referring to FIG. 12, a guide groove 713 for guiding a position of movement of the plurality of elastic supporters 300 may be further formed at the upper end of the air guide 700 according to the disclosure. Accordingly, the plurality of elastic supporters 300 may move to predetermine positions, and the position of the lower surface of the base plate 108 elastically supported by the plurality of elastic supporters 300 may change. Position change holes 711 may be spaced a predetermined distance apart in the guide groove 713.

Each elastic supporter 300 may be fixed at a position to which the elastic supporter 300 moves, through a position change hole 711 at a position to which the fixing hole 311 of the elastic supporter 300 moves and through a fixing screw (not illustrated). Accordingly, the elastic supporters 300 may be fixed to the positions to which the elastic supporters move.

Further, positions supported by the plurality of elastic supporters 300 may be included in a surface area of the working coil 106a, 106b, 106c, 106d, 106e disposed at the upper end of the base plate 108, for example. That is, the plurality ofelastic supporters 300 may be disposed under/below the working coils 106a, 106b, 106c, 106d, 106e.

As described with reference to the above examples, according to the disclosure, the plurality of elastic supporters 300 at the upper end of the air guide 700 may be spaced at regular intervals and may support the lower portions of the base plates 108 on which the working coils 106a, 106b, 106c, 106d, 106e are disposed, thereby preventing the base plates 108 from sagging.

Further, according to the disclosure, since a gap between an object to be heated and the working coil 106a, 106b, 106c, 106d, 106e may be maintained, uniformity in heating the object to be heated may be ensured and heat generation of the working coil 106a, 106b, 106c, 106d, 106e may be prevented.

Furthermore, according to the disclosure, the lower portion of the base plate 108 on which the working coil 106a, 106b, 106c, 106d, 106e is disposed may be elastically supported, thereby absorbing an external impact applied to the base plate 108.

FIG. 13 is a view showing an example in which a reinforcing object or structure is further formed in an air guide according to the present disclosure.

Referring to FIG. 13, the air guide 700 according to the disclosure may include a reinforcing structure 740.

The reinforcing structure 740 may be formed to protrude from the upper end of the housing 710 of the air guide 700. The reinforcing structure 740 may be formed as a protruding object having a grid shape.

The reinforcing structure 740 may be formed to protrude from a side of the air guide 700.

Certainly, another reinforcing structure (not illustrated) with an injection-molded metallic frame may be buried into the air guide 700.

The reinforcing structure 740 may prevent sagging of the upper end of the air guide 700.

That is, elastic supporters 300 may be disposed at a plurality of positions of the upper end of the air guide 700. The elastic supporters 300 may support the lower surface of the base plate 108 that allows the working coil 106a, 106b, 106c, 106d, 106e to be placed at the upper end thereof.

Accordingly, a predetermined self-weight may be applied to the elastic supporters 300 along the downward direction. The self-weight may be applied to the housing 710 where the elastic supporter 300 is disposed. When the housing 710 is made of plastics and has a predetermined small thickness, a portion of the upper end of the housing 710 where the elastic supporters 300 are disposed may sag downward. To solve the problem, the reinforcing structure 740 according to the disclosure may help to increase rigidity of the upper end of the housing 710 and readily prevent the downward sagging of the upper end of the housing 710, caused by the self-weight.

Though not illustrated in the drawings, support rods may be further formed along upward and downward directions on an inner surface of the upper end of the housing 710. Lower ends of the support rods may be disposed in the outside area of the driving circuit 110 and supported by the bottom surface of the case 102, for example.

Alternatively, holes through which the support rods pass may be formed at the driving circuit 110. The lower ends of the support rods passing through the driving circuit 110 may be supported by the bottom surface of the case 102. Since upper ends of the support rods connect to the inner surface of the upper end of the housing and the lower ends are supported by the bottom surface of the case 102, the upper end of the housing may be prevented from sagging downward.

As a result, the upper end of the housing 710 of the air guide 700 may be prevented from being deformed through the elastic supporters 300 supporting the lower surface of the base plate 108, thereby supporting the base plate 108 more stably, according to the present disclosure.

**Description of reference signs**

| | | | |
|---|---|---|---|
| 100: | Electric range | 102: | Case |
| 1021: | Mounting portion | 1023a: | 1-1th through hole |
| 1023b: | 1-2th through hole | 1023c: | 1-3th through hole |
| 1024a: | 2-1th through hole | 1024b: | 2-2th through hole |
| 1024c: | 2-3th through hole | 104: | Cover plate |
| 1041: | Input interface | 1042a: | First light display area |
| 1042b: | Second light display area | 1042c: | Third light display area |
| 1043a: | First light source unit | 1043b: | Second light source unit |
| 1043c: | Third light source unit | 106a: | First working coil |
| 106b: | Second working coil | 106c: | Third working coil |
| 106d: | Fourth working coil | 106e: | Fifth working coil |
| 108a: | First base plate | 108b: | Second base plate |
| 108c: | Third base plate | 110a: | First driving circuit |
| 110b: | Second driving circuit | 110c: | Third driving circuit |
| 112a: | First heat sink | 112b: | Second heat sink |
| 112c: | Third heat sink | 114: | Power feeder |
| 116a: | First filter circuit | 116b: | Second filter circuit |
| 116c: | Third filter circuit | 118a: | First air blowing fan |
| 118b: | Second air blowing fan | 118c: | Third air blowing fan |
| 700: | First air guide | 700: | Second air guide |
| 700: | Third air guide | 200: | Supporter |
| 210: | Bracket | 220: | Elastic member |
| 300: | Elastic supporter | 310: | Fixed piece |
| 320: | Elastic piece | 330: | Support piece |

## Claims

1. An electric range, comprising:
a case (102) having an inner space and an upper portion being open;
a base plate (108) disposed in the inner space to separate the inner space into the upper portion and a lower portion of the case (102);
a substrate and an air blowing fan (118) in the lower portion of the case (102),
a working coil (106) disposed in the upper portion and on the base plate (108; and
an air guide (700) disposed under/below the base plate (108) in the lower portion of the case (102), the air guide (700) is configured to cover the substrate, and having an inlet (720) disposed at the air blowing fan (118); **characterised by**
an elastic supporter (300) disposed between the air guide (700) and the base plate (108), and configured to elastically support different positions of a lower surface of the base plate (108).

2. The electric range of claim 1, wherein the air guide (700) has a predetermined length along a widthwise direction of the base plate (108), wherein a plurality of elastic supporters (300) is provided, spaced a predetermined distance apart along the widthwise direction, and disposed at a plurality of positions of an upper end of the air guide (700).

3. The electric range of claim 1 or 2, wherein the one or more elastic supporters (300) is a leaf spring, rubber block or sponge.

4. The electric range of any one of claim 1, 2 or 3, whereinan upper end of the air guide (700) includes at least one fixing portion for fixing the elastic supporter (300) at a plurality of positions of the upper end of the air guide, preferably there are more than one fixing portion on the upper end of the air guide (700).

5. The electric range of claim 4, wherein the fixing portion comprises a pair of support projections (712) spaced a predetermined distance apart at the upper end of the air guide (700) and protruding upward, and/or a fixing projection having a first fixing hole (711) protruding from the upper end of the air guide (700) such that the fixing projection is disposed between the pair of the support projections, wherein a lower end of the elastic supporter (300) is mounted onto upper ends of the pair of support projections (712),while a lower end of the elastic supporter (300) is mounted onto an upper end of the fixing projection (711), a second fixing hole (311) formed at the lower end of the elastic supporter (300) is mounted such that a position of the second fixing hole (311) is aligned with a position of the first fixing hole (711), and the first fixing hole (711) and the second fixing hole (311) are coupled through a fixing member.

6. The electric range of any one of the preceding claims, wherein each of the plurality of elastic supporters (300) comprises a first fixed piece (310) having a plate shape and fixed to the upper end of the air guide (700), a second fixed piece (330) having a plate shape and configured to support a lower surface of the base plate (108), and
an elastic piece (320) formed to spread apart and connected at one end to the first fixed piece (310) and at the other end to the second fixed piece (330).

7. The electric range of any one of the preceding claims, wherein a movement guide groove (713) is formed at the upper end of the air guide (700) along a lengthwise direction of the air guide (700), wherein the elastic supporter (300) is couplable to the movement guide groove (713) in a movable manner.

8. The electric range of any one of the preceding claims, wherein a reinforcing structure (740) having a grid shape is further formed at the air guide (700).

9. The electric range of any one of the preceding claims, wherein a plurality of base plates (108a, 108b, 108c) is disposed at an upper end of the case (102) adjacent to each other, and a plurality of elastic supporters (300) is provided to support a lower end of each of the base plates (108a, 180b, 180c).

10. The electric range of any one of the preceding claims, wherein a supporter (200) is further disposed on a bottom surface of the inner space of the case (102), wherein the supporter (200) includes a bracket (210) both end portions of which are supported by the bottom surface (102b) of the inner space of the case (102), and a plurality of elastic members (220) is disposed at a plurality of positions of an upper end of the bracket (210) and elastically supports a lower surface of the base plate (108).

11. The electric range of any one of the preceding claims, wherein the working coil (106) is disposed in a central portion of the base plate (108), wherein the elastic supporter (300) is disposed to support a lower end of the central portion of the base plate (108).

12. The electric range of any one of the preceding claims, wherein the elastic supporter (300) is disposed to support an area under/below a central portion of the working coil (106) at the lower end of the base plate (108).

13. The electric range of any one of the preceding claims, wherein a plurality of working coils (106, 106b, 106c) is provided, wherein the elastic supporter (300) is disposed to support a lower surface of the base plate (108a) on which a heaviest working coil (106a) among the plurality of working coils (106, 106b, 106c) is disposed.

14. The electric range of any one of the preceding claims, wherein the elastic supporter (300) is disposed to support an area of the base plate (108a, 108b, 108c), on which the working coil (106a, 106b, 106c) is disposed.

15. The electric range of any one of the preceding claims, wherein a plurality of base plates (108a, 108b, 108c) are provided and disposed to be adjacent to one another, wherein the elastic supporter (300) is disposed to support a lower portion of a base plate (108a) disposed at a center of among the plurality of base plates (108a, 108b, 108c).

## Patentansprüche

1. Elektrisches Kochfeld, das Folgendes umfasst:
ein Gehäuse (102), das einen Innenraum und einen oberen Abschnitt, der offen ist, aufweist;
eine Grundplatte (108), die im Innenraum angeordnet ist, derart, dass der Innenraum in den oberen Abschnitt und einen unteren Abschnitt des Gehäuses (102) getrennt ist;
ein Substrat und ein Luftgebläse (118) im unteren Abschnitt des Gehäuses (102);
eine Arbeitsspule (106), die im oberen Abschnitt und auf der Grundplatte (108) angeordnet ist; und
eine Luftführung (700), die unter/unterhalb der Grundplatte (108) im unteren Abschnitt des Gehäuses (102) angeordnet ist, wobei die Luftführung (700) konfiguriert ist, das Substrat abzudecken, und einen Einlass (720) aufweist, der am Luftgebläse (118) angeordnet ist;
**gekennzeichnet durch**
ein elastisches Trägerelement (300), das zwischen der Luftführung (700) und der Grundplatte (108) angeordnet ist und konfiguriert ist, verschiedene Positionen einer unteren Fläche der Grundplatte (108) elastisch zu tragen.

2. Elektrisches Kochfeld nach Anspruch 1, wobei die Luftführung (700) eine vorgegebene Länge entlang einer Breitenrichtung der Grundplatte (108) aufweist, wobei mehrere elastische Trägerelemente (300) vorgesehen sind, die um einen vorgegebenen Abstand entlang der Breitenrichtung beabstandet und an mehreren Positionen eines oberen Endes der Luftführung (700) angeordnet sind.

3. Elektrisches Kochfeld nach Anspruch 1 oder 2, wobei das eine oder die mehreren elastischen Trägerelemente (300) eine Blattfeder, ein Gummiblock oder ein Schwamm sind.

4. Elektrisches Kochfeld nach einem der Ansprüche 1, 2 oder 3, wobei ein oberes Ende der Luftführung (700) mindestens einen Befestigungsabschnitt zum Befestigen des elastischen Trägerelements (300) an mehreren Positionen des oberen Endes der Luftführung enthält, wobei es vorzugsweise mehr als einen Befestigungsabschnitt auf dem oberen Ende der Luftführung (700) gibt.

5. Elektrisches Kochfeld nach Anspruch 4, wobei der Befestigungsabschnitt ein Paar Trägervorsprünge (712), die am oberen Ende der Luftführung (700) um einen vorgegebenen Abstand beabstandet sind und nach oben vorstehen, und/oder einen Befestigungsvorsprung mit einem ersten Befestigungsloch (711), der vom oberen Ende der Luftführung (700) vorsteht, derart, dass der Befestigungsvorsprung zwischen dem Paar der Trägervorsprünge angeordnet ist, umfasst, wobei ein unteres Ende des elastischen Trägerelements (300) auf den oberen Enden des Paares Trägervorsprünge (712) angebracht ist, während ein unteres Ende des elastischen Trägerelements (300) auf einem oberen Ende des Befestigungsvorsprungs (711) angebracht ist, ein zweites Befestigungsloch (311), das am unteren Ende des elastischen Trägerelements (300) gebildet ist, derart angebracht ist, dass eine Position des zweiten Befestigungslochs (311) auf eine Position des ersten Befestigungslochs (711) ausgerichtet ist, und das erste Befestigungsloch (711) und das zweite Befestigungsloch (311) durch ein Befestigungselement gekoppelt sind.

6. Elektrisches Kochfeld nach einem der vorhergehenden Ansprüche, wobei die mehreren elastischen Trägerelemente (300) jeweils ein erstes feststehendes Stück (310), das eine Plattenform aufweist und am oberen Ende der Luftführung (700) befestigt ist, ein zweites feststehendes Stück (330), das eine Plattenform aufweist und konfiguriert ist, eine untere Fläche der Grundplatte (108) zu tragen, und
ein elastisches Stück (320), das derart ausgebildet ist, dass es auseinandergespreizt ist und an einem Ende mit dem ersten feststehenden Stück (310) und am anderen Ende mit dem zweiten feststehenden Stück (330) verbunden ist, umfassen.

7. Elektrisches Kochfeld nach einem der vorhergehenden Ansprüche, wobei eine Bewegungsführungsrille (713) am oberen Ende der Luftführung (700) entlang einer Längsrichtung der Luftführung (700) gebildet ist, wobei das elastische Trägerelement (300) auf eine bewegliche Weise mit der Bewegungsführungsrille (713) koppelbar ist.

8. Elektrisches Kochfeld nach einem der vorhergehenden Ansprüche, wobei ferner eine Verstärkungsstruktur (740), die eine Gitterform aufweist, an der Luftführung (700) gebildet ist.

9. Elektrisches Kochfeld nach einem der vorhergehenden Ansprüche, wobei mehrere Grundplatten (108a, 108b, 108c) an einem oberen Ende des Gehäuses (102) zueinander benachbart angeordnet sind und mehrere elastische Trägerelemente (300) vorgesehen sind, um ein unteres Ende von jeder der Grundplatten (108a, 180b, 180c) zu tragen.

10. Elektrisches Kochfeld nach einem der vorhergehenden Ansprüche, wobei ferner ein Trägerelement (200) auf einer Bodenfläche des Innenraums des Gehäuses (102) angeordnet ist, wobei das Trägerelement (200) einen Winkel (210) enthält, dessen beide Endabschnitte durch die Bodenfläche (102b) des Innenraums des Gehäuses (102) getragen werden, und mehrere elastische Elemente (220) an mehreren Positionen eines oberen Endes des Winkels (210) angeordnet sind und eine untere Fläche der Grundplatte (108) elastisch tragen.

11. Elektrisches Kochfeld nach einem der vorhergehenden Ansprüche, wobei die Arbeitsspule (106) in einem Mittelabschnitt der Grundplatte (108) angeordnet ist, wobei das elastische Trägerelement (300) derart angeordnet ist, dass ein unteres Ende des Mittelabschnitts der Grundplatte (108) getragen wird.

12. Elektrisches Kochfeld nach einem der vorhergehenden Ansprüche, wobei das elastische Trägerelement (300) derart angeordnet ist, dass ein Bereich unter/unterhalb eines Mittelabschnitts der Arbeitsspule (106) am unteren Ende der Grundplatte (108) getragen wird.

13. Elektrisches Kochfeld nach einem der vorhergehenden Ansprüche, wobei mehrere Arbeitsspulen (106, 106b, 106c) vorgesehen sind, wobei ein elastisches Trägerelement (300) derart angeordnet ist, dass eine untere Fläche der Grundplatte (108a) getragen wird, auf der eine schwerste Arbeitsspule (106a) von den mehreren Arbeitsspulen (106, 106b, 106c) angeordnet ist.

14. Elektrisches Kochfeld nach einem der vorhergehenden Ansprüche, wobei das elastische Trägerelement (300) derart angeordnet ist, dass ein Bereich der Grundplatte (108a, 108b, 108c) getragen wird, auf dem die Arbeitsspule (106a, 106b, 106c) angeordnet ist.

15. Elektrisches Kochfeld nach einem der vorhergehenden Ansprüche, wobei mehrere Grundplatten (108a, 108b, 108c) vorgesehen sind und derart angeordnet sind, dass sie zueinander benachbart sind, wobei das elastische Trägerelement (300) derart angeordnet ist, dass ein unterer Abschnitt einer Grundplatte (108a), die in einer Mitte angeordnet ist, von den mehreren Grundplatten (108a, 108b, 108c) getragen wird.

## Revendications

1. Cuisinière électrique, comportant :
un caisson (102) ayant un espace intérieur et une partie supérieure ouverte ;
une plaque de base (108) disposée dans l'espace intérieur pour séparer l'espace intérieur en la partie supérieure et une partie inférieure du caisson (102) ;
un substrat et un ventilateur de soufflage d'air (118) dans la partie inférieure du caisson (102),
une bobine de travail (106) disposée dans la partie supérieure et sur la plaque de base (108) ; et
un guide d'air (700) disposé sous/en dessous de la plaque de base (108) dans la partie inférieure du caisson (102), le guide d'air (700) étant configuré pour recouvrir le substrat, et ayant une entrée (720) disposée sur le ventilateur de soufflage d'air (118) ; **caractérisée par**
un élément de support élastique (300) disposé entre le guide d'air (700) et la plaque de base (108), et configuré pour supporter élastiquement différentes positions d'une surface inférieure de la plaque de base (108).

2. Cuisinière électrique selon la revendication 1, dans laquelle le guide d'air (700) a une longueur prédéterminée le long d'une direction de largeur de la plaque de base (108), dans lequel une pluralité d'éléments de support élastiques (300) est prévue, espacés d'une distance prédéterminée le long de la direction de largeur, et disposés à une pluralité de positions d'une extrémité supérieure du guide d'air (700).

3. Cuisinière électrique selon la revendication 1 ou 2, dans laquelle l'élément ou les éléments de support élastiques (300) sont un ressort à lame, un bloc en caoutchouc ou une éponge.

4. Cuisinière électrique selon l'une quelconque des revendications 1, 2 ou 3, dans laquelle une extrémité supérieure du guide d'air (700) inclut au moins une partie de fixation pour fixer l'élément de support élastique (300) à une pluralité de positions de l'extrémité supérieure du guide d'air, plusieurs positions de fixation étant de préférence prévues sur l'extrémité supérieure du guide d'air (700).

5. Cuisinière électrique selon la revendication 4, dans laquelle la partie de fixation comporte une paire de saillies de support (712) espacées d'une distance prédéterminée au niveau de l'extrémité supérieure du guide d'air (700) et faisant saillie vers le haut, et/ou une saillie de fixation ayant un premier trou de fixation (711) faisant saillie depuis l'extrémité supérieure du guide d'air (700) de telle sorte que la saillie de fixation est disposée entre la paire des saillies de support, dans laquelle une extrémité inférieure de l'élément de support élastique (300) est montée sur des extrémités supérieures de la paire de saillies de support (712), alors qu'une extrémité inférieure de l'élément de support élastique (300) est montée sur une extrémité supérieure de la saillie de fixation (711), un second trou de fixation (311) formé au niveau de l'extrémité inférieure de l'élément de support élastique (300) est monté de telle sorte qu'une position du second trou de fixation (311) est alignée avec une position du premier trou de fixation (711), et le premier trou de fixation (711) et le second trou de fixation (311) sont couplés par un élément de fixation.

6. Cuisinière électrique selon l'une quelconque des revendications précédentes, dans laquelle chaque élément de la pluralité d'éléments de support élastiques (300) comporte une première pièce fixe (310) ayant une forme de plaque et fixée à l'extrémité supérieure du guide d'air (700), une seconde pièce fixe (330) ayant une forme de plaque et configurée pour supporter une surface inférieure de la plaque de base (108), et
une pièce élastique (320) formée pour s'écarter et reliée, au niveau d'une extrémité, à la première pièce fixe (310) et, au niveau de l'autre extrémité, à la seconde pièce fixe (330).

7. Cuisinière électrique selon l'une quelconque des revendications précédentes, dans laquelle une rainure de guidage de mouvement (713) est formée au niveau de l'extrémité supérieure du guide d'air (700) le long d'une direction de longueur du guide d'air (700), dans laquelle l'élément de support élastique (300) peut être couplé à la rainure de guidage de mouvement (713) d'une manière mobile.

8. Cuisinière électrique selon l'une quelconque des revendications précédentes, dans laquelle une structure de renfort (740) ayant une forme de grille est en outre formée sur le guide d'air (700).

9. Cuisinière électrique selon l'une quelconque des revendications précédentes, dans laquelle les plaques d'une pluralité de plaques de base (108a, 108b, 108c) sont disposées sur une extrémité supérieure du caisson (102) au voisinage les unes des autres, et une pluralité d'éléments de support élastiques (300) est prévue pour supporter une extrémité inférieure de chacune des plaques de base (108a, 108b, 108c).

10. Cuisinière électrique selon l'une quelconque des revendications précédentes, dans laquelle un élément de support (200) est en outre disposé sur une surface de fond de l'espace intérieur du caisson (102), dans laquelle l'élément de support (200) inclut une équerre (210) dont les deux parties d'extrémité sont supportées par la surface de fond (102b) de l'espace intérieur du caisson (102), et une pluralité d'éléments élastiques (220) est disposée à une pluralité de positions d'une extrémité supérieure de l'équerre (210) et supporte élastiquement une surface inférieure de la plaque de base (108).

11. Cuisinière électrique selon l'une quelconque des revendications précédentes, dans laquelle la bobine de travail (106) est disposée dans une partie centrale de la plaque de base (108), dans laquelle l'élément de support élastique (300) est disposé de manière à supporter une extrémité inférieure de la partie centrale de la plaque de base (108).

12. Cuisinière électrique selon l'une quelconque des revendications précédentes, dans laquelle l'élément de support élastique (300) est disposé de manière à supporter une zone sous/en dessous d'une partie centrale de la bobine de travail (106) à l'extrémité inférieure de la plaque de base (108).

13. Cuisinière électrique selon l'une quelconque des revendications précédentes, dans laquelle une pluralité de bobines de travail (106, 106b, 106c) est prévue, dans laquelle l'élément de support élastique (300) est disposé de manière à supporter une surface inférieure de la plaque de base (108a) sur laquelle est disposée une bobine de travail (106a) la plus lourde parmi la pluralité de bobines de travail (106, 106b, 106c).

14. Cuisinière électrique selon l'une quelconque des revendications précédentes, dans laquelle l'élément de support élastique (300) est disposé de manière à supporter une zone de la plaque de base (108a, 108b, 108c), sur laquelle la bobine de travail (106a, 106b, 106c) est disposée.

15. Cuisinière électrique selon l'une quelconque des revendications précédentes, dans laquelle les plaques d'une pluralité de plaques de base (108a, 108b, 108c) sont fournies et disposées de manière à être adjacentes les unes aux autres, dans laquelle l'élément de support élastique (300) est disposé de manière à supporter une partie inférieure de la plaque de base (108a) disposée en un centre de la pluralité de plaques de base (108a, 108b, 108c) .
